# FASCICULE DE BREVET EUROPEEN

(11) **EP 3 208 818 B1**
(45) Date de publication et mention de la délivrance du brevet: **23.01.2019**
(21) Numéro de dépôt: 17156598.9
(22) Date de dépôt: 17.02.2017
(51) Int. Cl.: H01H 9/22, H01H 71/56

(54) **DISPOSITIF DE COMMANDE À DISTANCE D'UN APPAREIL ÉLECTRIQUE DANS UNE ARMOIRE ÉLECTRIQUE**
FERNSTEUERUNG EINES IN EINEM ELEKTROSCHRANK SICH BEFINDENDEN ELEKTROGERÄTES
REMOTE CONTROL APPARATUS FOR AN ELECTRICAL DEVICE IN AN ELECTRICAL PANEL

(30) Priorité: 19.02.2016 FR 1651364
(43) Date de publication de la demande: 23.08.2017
(73) Titulaire: Schneider Electric Industries SAS, 92500 Rueil-Malmaison (FR)
(72) Inventeur: SINTHOMEZ, Daniel, 38050 Grenoble Cedex 09 (FR); PITIS, Florent, 38050 Grenoble Cedex 09 (FR)
(74) Mandataire: Lavoix

(56) Documents cités:
- DE-A1-102013 112 570
- US-A- 5 609 244
- US-A1- 2010 300 860
- US-A1- 2015 364 277

## Description

L'invention concerne un dispositif de commande à distance d'un appareil électrique disposé dans une armoire électrique. L'invention concerne également une armoire électrique comprenant un appareil électrique commandable et un tel dispositif de commande à distance pour commander l'appareil électrique depuis l'extérieur de l'armoire.

De façon connue, dans des installations électriques industrielles ou domotiques, des appareils électriques tels que des disjoncteurs sont installés dans des coffrets ou des armoires électriques. Ces armoires sont typiquement fermées par une porte munie d'une serrure, pour empêcher l'accès aux appareils électriques pendant leur fonctionnement, de manière à éviter qu'un utilisateur ne puisse entrer en contact avec une partie de l'installation électriquement sous tension. Pour des raisons de sécurité, un dispositif de commande à distance de l'appareil est placé sur l'armoire pour commander l'appareil depuis l'extérieur de l'armoire, même lorsque la porte est fermée. Par exemple, une poignée de commande est installée à l'extérieur de la paroi et est reliée mécaniquement à l'appareil électrique pour l'allumer ou pour l'éteindre.

Souvent, sur des installations préexistantes, l'appareil électrique est pourvu d'un levier de commande qui n'est actionnable que lorsque la porte est ouverte. On installe alors un dispositif de commande à distance dédié, qui est rapporté sur cet appareil électrique et qui est couplé mécaniquement au levier de commande. Une poignée est alors installée sur la porte de l'armoire, en face de l'appareil.

Pour des raisons d'encombrement et d'ergonomie, il est parfois souhaitable de placer la poignée de commande sur une face latérale de l'armoire, quand bien même l'appareil électrique ne prévoit pas nativement une telle configuration.

C'est à ces inconvénients qu'entend plus particulièrement remédier l'invention en proposant un dispositif de commande à distance d'un levier de commande d'un appareil électrique installé dans une armoire électrique, ce dispositif de commande pouvant être installé indifféremment sur un flanc latéral droit ou gauche de l'armoire électrique en étant décalé par rapport à la face de l'appareil électrique qui porte le levier de commande. Le document "US 5 609 244 A" décrit (les signes de référence entre parenthèses s'appliquent à ce document) un dispositif de commande (10) à distance d'un appareil électrique (78) dans une armoire électrique (11), cette armoire incluant une paroi de fond (13) et des parois latérales (16) s'étendant essentiellement perpendiculairement par rapport à la paroi de fond et délimitant un logement, un appareil électrique (78) étant fixé, sur la paroi de fond, à l'intérieur du logement, ce dispositif comportant : un organe rotatif de commande (86), apte à être fixé sur une paroi de l'armoire (11) à l'extérieur du logement, cet organe rotatif de commande (86) étant sélectivement déplaçable entre des première et deuxième configurations, un système de transmission (101) apte à relier mécaniquement l'organe rotatif (86) de commande à un axe de commande de l'appareil électrique, cet axe de commande étant déplaçable entre des première et deuxième positions, le système de transmission (101) étant configuré pour que le déplacement de l'organe rotatif de commande (86) entre ses première et deuxième configurations entraîne en déplacement l'axe de commande respectivement entre ses première et deuxième positions, l'organe rotatif de commande (86) étant destiné à être monté sur une des parois latérales (16) du logement et est mobile en rotation.

A cet effet, l'invention concerne un dispositif de commande à distance d'un appareil électrique dans une armoire électrique, cette armoire incluant une paroi de fond et des parois latérales s'étendant essentiellement perpendiculairement par rapport à la paroi de fond et délimitant un logement, un appareil électrique étant fixé, sur la paroi de fond, à l'intérieur du logement, ce dispositif comportant :
- un organe rotatif de commande, apte à être fixé sur une paroi de l'armoire à l'extérieur du logement, cet organe rotatif de commande étant sélectivement déplaçable entre des première et deuxième configurations,
- un système de transmission apte à relier mécaniquement l'organe rotatif de commande à un levier de commande de l'appareil électrique, ce levier de commande étant déplaçable entre des première et deuxième positions, le système de transmission étant configuré pour que le déplacement de l'organe rotatif de commande entre ses première et deuxième configurations entraîne en déplacement le levier de commande respectivement entre ses première et deuxième positions.
Conformément à l'invention, l'organe rotatif de commande est destiné à être monté sur une des parois latérales du logement et est mobile en rotation et le système de transmission comporte :
- un premier pignon, solidaire en rotation avec l'organe rotatif de commande autour d'un premier axe fixe, essentiellement perpendiculaire aux parois latérales
- un deuxième pignon, engrené avec le premier pignon et mobile en rotation autour d'un deuxième axe fixe perpendiculaire au premier axe fixe, ce deuxième pignon étant destiné à être couplé mécaniquement avec le levier de commande pour déplacer ce levier de commande entre ses première et deuxième positions lorsque le deuxième pignon se déplace en rotation.

Grâce à l'invention, l'organe rotatif peut être placé sur n'importe laquelle des parois latérales de l'armoire. Le système de transmission induit que l'organe rotatif de commande peut être tourné dans un même sens de rotation selon qu'il se trouve d'un côté ou de l'autre de l'armoire, pour déplacer le levier de commande vers un même état.

Ainsi, l'installation de l'appareil s'en trouve facilitée.

En effet, pour des raisons d'ergonomie, il est souhaitable de respecter un sens de rotation prédéfini pour commuter l'appareil entre ses positions de marche et d'arrêt. Le système de transmission qui relie la poignée de commande au levier de l'appareil électrique doit donc être adapté selon que l'utilisateur souhaite installer la poignée de commande sur un flanc droit ou sur un flanc gauche de l'armoire électrique. Les dispositifs connus ne sont pas les mêmes selon qu'ils sont prévus pour être installés d'un côté ou de l'autre de l'armoire électrique. Cela induit des contraintes logistiques, car il est nécessaire de fabriquer deux versions différentes du système de commande pour l'appareil électrique. L'installation d'une armoire électrique comportant un appareil pourvu d'un tel dispositif de commande connu s'en trouve ainsi plus compliquée, car l'installateur doit disposer des pièces appropriées en fonction du côté duquel il aura choisi d'installer la poignée de commande.

Au contraire, grâce à l'invention, le dispositif de commande fonctionne avec un même organe rotatif de commande qui peut être installé sur n'importe quelle paroi latérale de l'armoire électrique.

Selon des aspects avantageux mais non obligatoires de l'invention, un tel dispositif de commande peut incorporer une ou plusieurs des caractéristiques suivantes, prise(s) dans toute combinaison techniquement admissible :
- L'organe rotatif de commande comporte une poignée rotative montée sur la paroi latérale et un arbre s'étendant essentiellement le long d'un troisième axe et qui solidarise en rotation, autour du premier axe, une portion mobile de la poignée rotative avec le premier pignon ;
- L'organe rotatif de commande comporte un embout de liaison avec le premier pignon, cet embout de liaison étant solidaire sans degré de liberté avec une extrémité de l'arbre et présentant une tête reçue dans un logement de forme complémentaire ménagé sur le premier pignon pour solidariser l'arbre en rotation avec le premier pignon ;
- La tête de l'embout de liaison comporte un ergot faisant saillie par rapport à cette tête selon une direction essentiellement perpendiculaire au troisième axe, alors que le premier pignon comporte une cavité de forme complémentaire pour recevoir cet ergot lorsque l'embout est reçu dans le logement ;
- La tête de l'embout de liaison comporte une rotule, le premier pignon comportant un logement de forme complémentaire pour recevoir cette rotule ;
- Le troisième axe présente un décalage angulaire d'angle α par rapport au premier axe, l'angle α présentant une valeur inférieure ou égale à 10°, de préférence à 5°, de préférence encore à 2°.
- Le levier de commande est déplaçable entre ses première et deuxième positions par déplacement dans une direction essentiellement parallèle au plan contenant le fond du logement. Le système de transmission comporte un troisième pignon engrené avec le deuxième pignon et mobile en rotation autour d'un quatrième axe fixe parallèle au deuxième axe fixe, ce troisième pignon comportant des griffes conformées disposées de part et d'autre du levier de commande ;
- Le système de transmission comporte un boîtier à l'intérieur duquel sont disposés les premier et deuxième pignons, ce boîtier étant apte à être fixé sur l'appareil électrique pour en commander le déplacement du levier de commande.

Selon un autre aspect, l'invention concerne une armoire électrique, comportant une paroi de fond et des parois latérales s'étendant perpendiculairement par rapport à la paroi de fond, ces parois délimitant un logement, un appareil électrique, fixé à l'intérieur du logement sur la paroi de fond et comportant un levier de commande déplaçable entre des première et deuxième positions, un dispositif de commande à distance de l'appareil électrique, comprenant :
- un organe rotatif de commande, fixé sur une paroi de l'armoire à l'extérieur du logement, cet organe rotatif de commande étant sélectivement déplaçable entre des première et deuxième configurations,
- un système de transmission qui relie mécaniquement l'organe rotatif de commande au levier de commande, pour que le déplacement de l'organe rotatif de commande entre ses première et deuxième configurations entraîne en déplacement le levier de commande respectivement entre ses première et deuxième positions,
dans laquelle le dispositif de commande à distance est conforme à l'invention, l'organe rotatif de commande étant fixé sur une des parois latérales et étant mobile en rotation autour d'un troisième axe fixe essentiellement perpendiculaire à cette paroi latérale, le deuxième pignon étant couplé mécaniquement avec le levier de commande.

Selon des aspects avantageux mais non obligatoires de l'invention, une telle armoire électrique peut incorporer une ou plusieurs des caractéristiques suivantes, prise(s) dans toute combinaison techniquement admissible :
- une porte déplaçable sélectivement entre des positions d'ouverture et de fermeture du logement, et
- un système de verrouillage de la porte dans sa position fermée, ce système de verrouillage comportant un crochet et un anneau, l'un ou l'autre du crochet et de l'anneau, étant fixé sur une paroi intérieure de la porte, l'autre du crochet et de l'anneau étant monté sur le système de transmission et étant solidaire en rotation autour du troisième axe avec l'organe rotatif de commande, entre :
   - une position de verrouillage, dans laquelle, lorsque la porte est dans la position fermée, le crochet pénètre à l'intérieur de l'anneau et empêche le déplacement de la porte vers sa position ouverte, et
   - une position de déverrouillage, dans laquelle, lorsque la porte est dans la position fermée, le crochet et l'anneau sont distants l'un de l'autre et autorisent le déplacement de la porte vers sa position ouverte.
- L'autre est monté sur et solidaire en rotation avec l'arbre.

L'invention sera mieux comprise et d'autres avantages de celle-ci apparaitront plus clairement à la lumière de la description qui va suivre, d'un mode de réalisation d'un dispositif de commande donné uniquement à titre d'exemple non limitatif et faite en référence aux dessins annexés dans lesquels :
- les figures 1 et 2 sont des vues en perspectives écorchées, d'une armoire électrique contenant un appareil électrique pourvu d'un dispositif de commande selon l'invention dont des poignées rotatives de commande sont illustrées, respectivement, dans une première et une deuxième configuration ;
- la figure 3 est une représentation schématique d'un système de transmission du dispositif de commande selon l'invention ;
- la figure 4 est une vue en perspective d'un couplage mécanique entre un pignon du dispositif de commande de la figure 3 et un levier de commande de l'appareil électrique des figures 1 et 2 ;
- la figure 5 est une représentation schématique d'un embout de liaison entre la poignée rotative du dispositif de commande de la figure 1 et un des pignons du système de transmission de la figure 3 ;
- la figure 6 est une vue en perspective du système de transmission du dispositif des figures 1 et 2 dans lequel un arbre de raccordement de la poignée est inséré dans le premier pignon avec un décalage angulaire ;
- la figure 7 est une vue en perspective extérieure d'un repère d'alignement du dispositif de commande par rapport à l'armoire électrique pour l'installation du dispositif de commande ;
- les figures 8 à 10 sont des vues en perspectives d'un système de verrouillage de la porte de l'armoire couplé avec le dispositif de commande à distance selon l'invention.

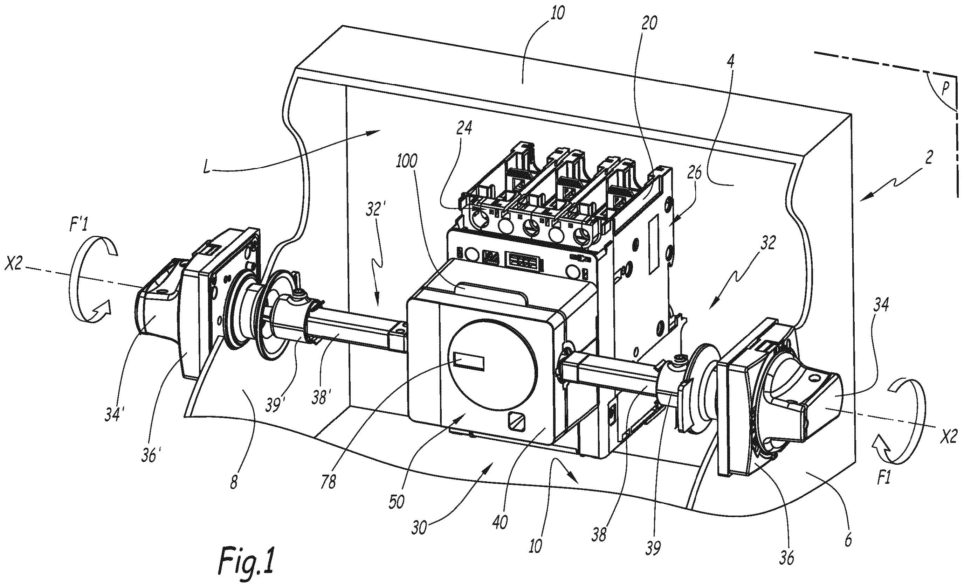

Sur la figure 1 est représentée une armoire électrique 2, qui comporte :
- une paroi de fond 4 qui s'étend essentiellement selon un plan géométrique P, ici vertical ;
- des parois latérales droite 6 et gauche 8 qui s'étendent perpendiculairement par rapport au plan P ;
- des parois d'extrémités 10 supérieure et inférieure qui s'étendent horizontalement et le long d'un plan géométrique perpendiculaire au plan P.

Les parois 4, 6, 8 et 10 délimitent ensemble un logement L intérieur de l'armoire 2.

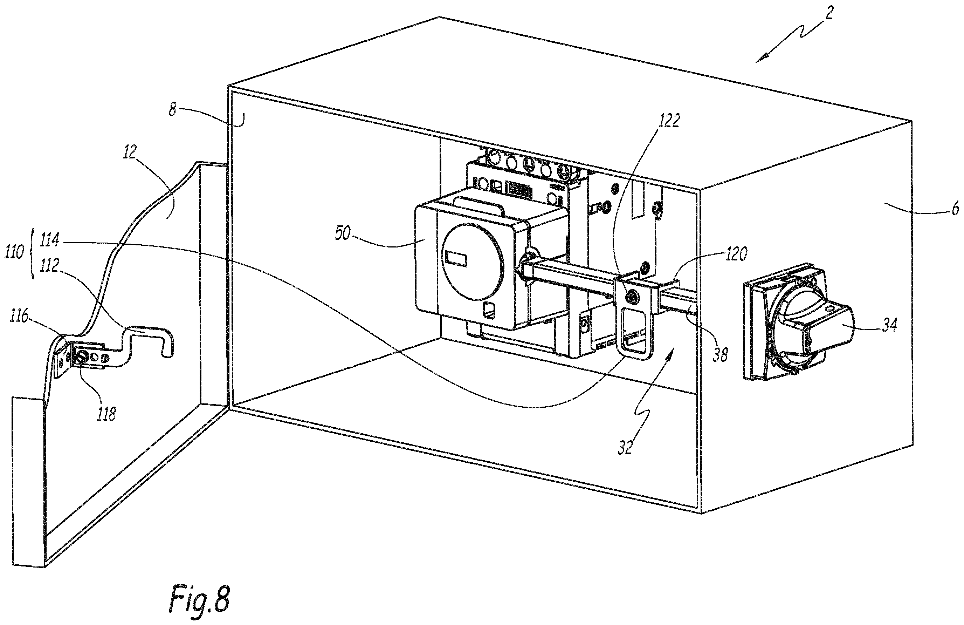

L'armoire 2 comporte également une porte 12, sélectivement déplaçable entre des positions fermée et ouverte. Par exemple, la porte 12 est montée pivotante par rapport à l'une des parois latérales 6 ou 8 au moyen d'une charnière. Dans la position fermée, la porte 12 referme le logement L. Dans la position ouverte, le logement L est ouvert vers l'extérieur de l'armoire 2. Pour simplifier, la porte 12 n'est représentée que sur les figures 8 à 10.

L'armoire 2 comporte en outre un appareil électrique 20, fixé à l'intérieur du logement L sur la paroi 4. L'appareil 20 est ici un disjoncteur. L'appareil 20 est par exemple raccordé électriquement à des conducteurs électriques qui pénètrent à l'intérieur de l'armoire 2 au moyen d'une ouverture ménagée sur une ou plusieurs parois de l'armoire 2, par exemple sur la paroi 4. Pour simplifier, ces conducteurs électriques ne sont pas illustrés sur les figures.

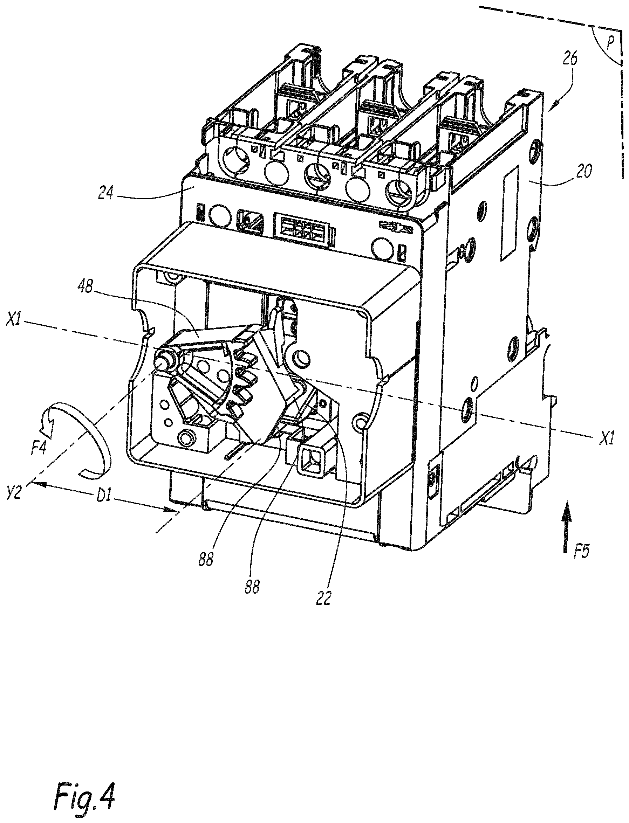

Comme illustré à la figure 4, l'appareil 20 comporte un levier de commande 22, ou basculeur, sélectivement et réversiblement déplaçable entre des première et deuxième positions stables correspondant chacune à un état électrique de l'appareil 20. Par exemple, la première position correspond à un état inactif, dit « OFF », de l'appareil 20 et la deuxième position correspond à un état actif, dit « ON », de l'appareil 20.

Le levier 22 est ici disposé sur une face avant 24 de l'appareil 20. La face avant 24 est disposée à l'opposé d'une face arrière 26 qui elle-même fixe l'appareil 20 à la paroi 4. Le levier 22 est monté pivotant de haut en bas entre ses première et deuxième positions autour d'un axe de rotation X1 fixe par rapport à l'appareil 20. Ici, l'axe X1 s'étend horizontalement et parallèlement au plan P. Le déplacement du levier 22 est réalisé en exerçant un effort en translation selon une direction parallèle au plan P. Cette direction est ici verticale.

L'armoire 2 comporte en outre un dispositif 30 de commande à distance de l'appareil 20, pour commander l'appareil 20 entre ses états électriques depuis l'extérieur de l'armoire 2, y compris lorsque la porte 12 de l'armoire 2 est en position fermée.

On note X2 un axe fixe du dispositif de commande 30. L'axe X2 s'étend essentiellement perpendiculairement à au moins l'une ou l'autre des parois latérales 6 et 8, voire aux deux parois latérales 6 et 8. L'axe X2 est décrit plus en détail dans ce qui suit.

Dans un exemple illustratif et non limitatif, le dispositif 30 comporte à cet effet deux organes rotatifs de commande 32 et 32' fixés, respectivement, sur les parois latérales 6 et 8. Les organes rotatifs 32 et 32' sont ici identiques. Par conséquent, seul l'organe rotatif 32 est décrit en détail dans ce qui suit. Tout ce qui est décrit en référence à l'organe rotatif 32 s'applique à l'organe rotatif 32'.

Selon une variante préférée, seul l'un ou l'autre des organes rotatifs 32 et 32' est présent dans le système 30.

L'organe rotatif 32 est déplaçable sélectivement et réversiblement entre des première et deuxième configurations stables, par rotation autour d'un axe de rotation fixe X3. Dans cet exemple, l'axe X3 est perpendiculaire à la paroi 6.

L'organe rotatif 32 comporte une poignée rotative de commande 34 qui inclut une partie préhensible rotative et une partie fixe 36 solidaire de la paroi 6. La poignée 34 est par exemple la poignée décrite dans le brevet EP 1 791 149 B1.

Dans cette description, sauf précision contraire, lorsqu'il est fait référence à la rotation de la poignée 34, il faut comprendre que c'est la partie mobile de cette poignée qui est déplacée en rotation, le support fixe 36 restant immobile par rapport à la paroi 6 sur laquelle la poignée 34 est montée. Il en va de même pour la poignée 34'.

L'organe rotatif 32 comporte en outre un arbre 38 qui s'étend essentiellement le long d'un axe X3. L'arbre 38 est solidaire en rotation avec la poignée 34 autour de l'axe X3. Par exemple, une extrémité distale de l'arbre 38 est fixée mécaniquement à un raccord 39 s'étendant solidairement et dans le prolongement avec la partie mobile de la poignée 34. L'arbre 38 présente ici une longueur, mesurée selon l'axe X3, préférentiellement comprise entre 40 mm et 500 mm. Dans cet exemple, lorsque le dispositif 32 est dans un état installé, l'axe X3 est confondu avec l'axe X2. Ainsi, l'ensemble formé de la poignée 34 et de l'arbre 38 est solidaire en rotation autour de l'axe X2. Dans ce qui suit, des première et deuxième configurations de la poignée 34 correspondent respectivement aux première et deuxième configurations de l'organe rotatif 32'.

L'organe rotatif 32' comporte une poignée 34', un support fixe 36', un arbre 38' et un raccord 39' qui jouent le même rôle, respectivement, que la poignée 34, le support fixe 36, l'arbre 38 et le raccord 39.

Le dispositif de commande 30 comporte en outre un système de transmission 40 qui relie mécaniquement l'organe rotatif 32 au levier de commande 22, de telle sorte que la rotation de l'organe rotatif 32 entre ses première et deuxième configurations entraine le déplacement le levier 22, entre ses première et deuxième positions.

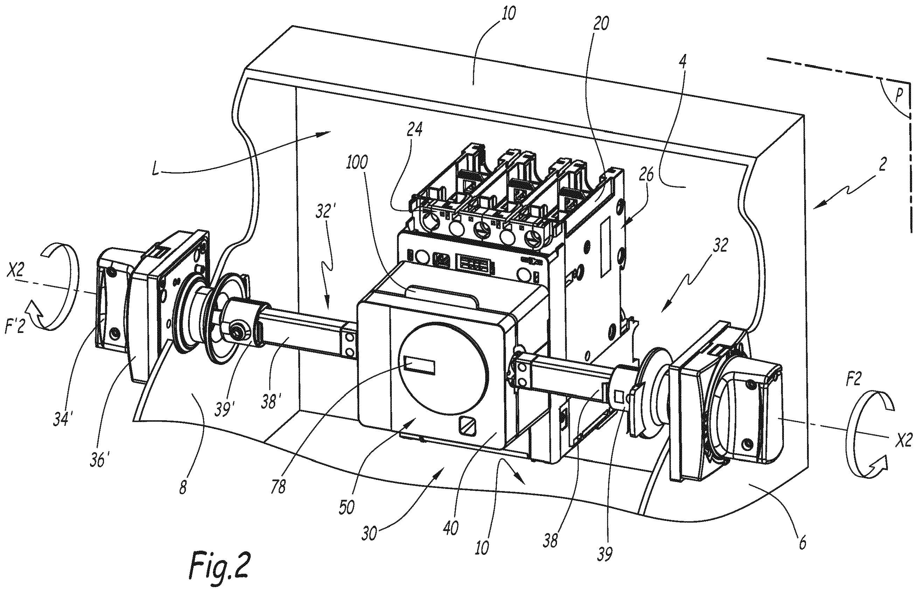

Dans cet exemple, la première configuration de la poignée 32 correspond à la première position du levier 22, qui correspond elle-même à l'état inactif de l'appareil 20. Dans sa première configuration, la partie mobile de la poignée 34 s'étend selon une direction horizontale, comme illustré à la figure 1. La deuxième configuration de l'organe rotatif 32 correspond à la deuxième position du levier 22, qui correspond elle-même à l'état actif de l'appareil 20. Dans la deuxième configuration, partie mobile de la poignée 34 s'étend selon une direction verticale, comme illustré à la figure 2.

Le déplacement de la poignée 34 depuis sa première configuration vers sa deuxième configuration est ici réalisé en faisant tourner la poignée 34 autour de l'axe X2 avec un angle de 90° dans un sens de rotation horaire, représenté par la flèche F1 à la figure 1. Le passage de la poignée 34 depuis sa deuxième configuration vers sa première configuration se fait en tournant cette poignée d'un angle de 90° autour de l'axe X2 dans le sens opposé, c'est-à-dire dans le sens antihoraire, représenté par la flèche F2. De telles configurations sont, en pratique, préférables pour des raisons d'ergonomie. De même, l'organe 32' est déplacé dans son sens horaire, illustré par la flèche F'1 à la figure 1, pour déplacer le levier 22 vers sa deuxième position, et, alternativement, est déplacé dans son sens antihoraire, illustré par la flèche F'2 à la figure 2, pour déplacer le levier 22 vers sa première position.

Pour chaque poignée 34, 34', le sens de rotation horaire est défini par rapport à un observateur qui observe cette poignée et se tenant face à la paroi latérale, respectivement, 6 et 8, à l'extérieur de l'armoire 2.

Plus précisément, le système de transmission 40 transforme la rotation de l'organe rotatif 32 en un déplacement essentiellement rectiligne du levier de commande 22 dans un plan de déplacement parallèle au plan géométrique P. Le dispositif 40 est avantageusement conformé pour que la rotation d'un angle de 90° de l'organe de commande 32 ou 32' entraine un déplacement du levier 22 sur tout le long de sa course, pour le basculer dans sa deuxième position.

Le système de transmission 40 comporte des pignons 42, 44, 46 et 48 dont le rôle est décrit plus en détail dans ce qui suit. Ces pignons 42, 44, 46 et 48 sont arrangés à l'intérieur d'un boîtier 50 du système 40. Le boîtier 50 présente ici une forme de trapèze à base parallélépipédique. Le boîtier 50 est fixé sur la face avant 24 de l'appareil 20. Par exemple, le boîtier 50 est réalisé en matière plastique. Le boîtier 50 comporte deux orifices latéraux chacun ménagés sur une paroi latérale de ce boîtier 50 faisant face, respectivement, aux parois 6 et 8 de l'armoire 2. Par exemple, le boîtier 50 présente une ouverture sur sa face arrière, c'est-à-dire celle tournée vers la face avant 24 de l'appareil 20, pour assurer un couplage mécanique avec le levier 22. Ainsi, le système 30 est facile à installer sur la face avant 24 d'un appareil 20 existant.

Le pignon 42 est monté libre en rotation autour de l'axe X2 par rapport au boitier 50. Ce pignon 42 est ici apte à être solidarisé en rotation avec l'organe rotatif 32 autour de l'axe X2. Par exemple, le pignon 42 comporte un logement 52 pour recevoir, de façon amovible, l'arbre 38.

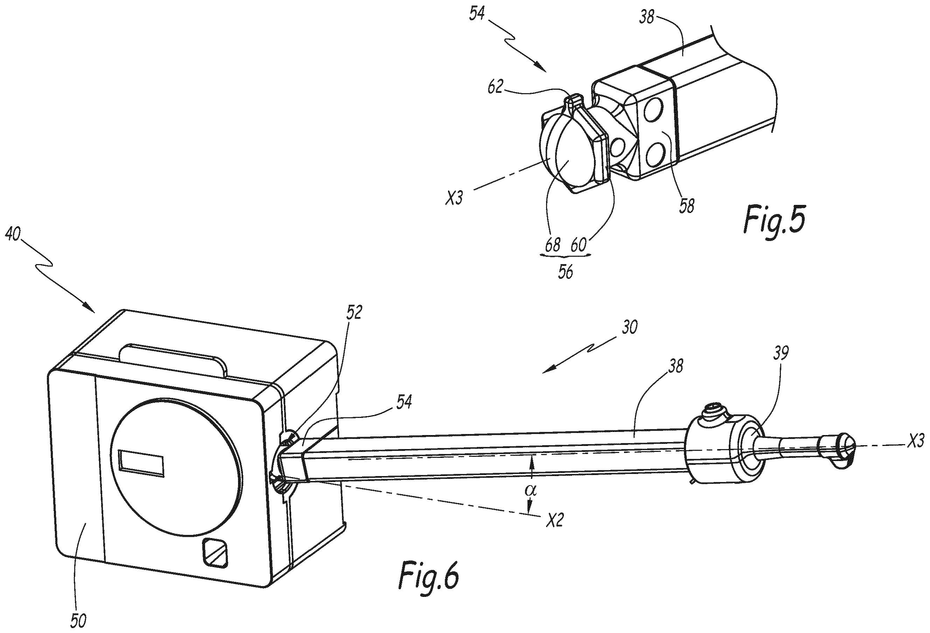

En l'espèce, l'organe rotatif 32 comporte un embout de liaison 54 qui est monté sur une extrémité distale de l'arbre 38, comme illustré à la figure 5, opposée à l'extrémité proximale de l'arbre reçue dans le raccord 39. L'embout 54 comporte une tête 56 et un corps 58 monté en force à l'intérieur d'un corps creux délimité à l'extrémité de l'arbre 38. La tête 56 est raccordée solidairement et sans aucun degré de liberté au corps 58. Par exemple, l'embout 54 est une pièce mécanique réalisée d'un seul tenant, ici réalisée en un alliage d'aluminium ou en matière plastique, par exemple par moulage.

En variante, le bras 38 est omis. Dans ce cas, l'embout 54 est reçu directement dans le raccord 39 pour solidariser en rotation la partie mobile de la poignée 34 avec le pignon 42.

La tête 56 et le logement 52 présentent des formes complémentaires l'une avec l'autre, de manière à ce que la tête 56 soit reçue à l'intérieur du logement 52 pour transmettre le mouvement de rotation autour de l'axe X2. Par exemple, la tête 56 comporte une portion périphérique 60, qui s'étend ici selon un plan perpendiculaire à l'arbre 38 et qui présente une section de forme hexagonale. Le logement 52 comporte une forme complémentaire, c'est-à-dire ici hexagonale et creuse, permettant le montage sans jeu de la tête 56. En variante, d'autres formes sont possibles, telle qu'une forme carrée ou une forme de n'importe quel autre polyèdre.

Avantageusement, l'embout 54 comporte un ergot 62 de positionnement faisant saillie par rapport à cette tête 54. L'ergot 62 fait ici saillie selon une direction perpendiculaire à l'axe X3. De préférence, l'ergot 62 est placé sur la portion périphérique 60. Le pignon 42 comporte également une cavité 64 de forme complémentaire à l'ergot 62, pour recevoir cet ergot 62 lorsque l'embout 54 est reçu dans le logement 52. L'ergot 62 et la cavité 64 facilitent l'insertion et le positionnement de l'organe rotatif de commande 32 dans le pignon 42. En effet, cela permet de faire correspondre les première et deuxième configurations de l'organe rotatif de commande 32 aux première et deuxième positions du levier 22. Du fait de l'ergot 62 et de la cavité 64, l'organe rotatif 32 ne peut être inséré dans le pignon 42 que s'il est positionné de telle sorte que l'ergot 62 soit en face de la cavité 64. Il en va de même pour le pignon 44.

Avantageusement, la tête 56 de l'embout 54 comporte une rotule 68. La rotule 68 est ici placée sur l'extrémité distale de l'embout 54, dans le prolongement de la portion 60. Le pignon 42 comporte un logement de forme complémentaire pour recevoir cette rotule 68. Par exemple, un tel logement est situé à l'intérieur du pignon 42 dans le prolongement du logement 52.

La rotule 68 forme avec le pignon 42 une liaison rotule qui autorise un décalage angulaire entre l'axe X2 de rotation du pignon 42 et l'axe X3 de l'organe rotatif 32 lorsque ce dernier est dans un état installé dans le dispositif 30. On note α l'angle entre les axes X2 et X3. L'angle α présente une valeur absolue inférieure ou égale à 10°, de préférence à 5°, de préférence encore à 2°. De préférence, l'angle α est nul.

La liaison rotule autorise un désalignement de l'organe rotatif 32 qui résulterait d'une erreur de montage du système 30, comme illustré à la figure 6. En effet, pour monter le système 30 dans l'armoire 2, un utilisateur doit percer un trou dans la paroi latérale 6 pour y placer la poignée 34 de l'organe rotatif 32. Ce perçage doit être tel que le centre du trou se trouve en face du logement 52 du pignon 42 et aligné sur l'axe X2. Il est fréquent qu'un tel trou soit percé avec une légère erreur de position, par exemple tel que le centre du trou se trouve à une distance inférieure à 1 cm ou à 5 mm de l'axe X2. Il en résulte en un désalignement de l'axe X3 par rapport à l'axe X2. Grâce à la rotule 68 et au pignon 42, la rotation de l'organe rotatif de commande 32 autour de l'axe X3 permet tout de même d'entrainer en rotation le pignon 42 autour de l'axe X2 et donc de commander le déplacement du levier de commande 22 entre ses première et deuxième positions. Malgré ce désalignement, la portion périphérique 60 est au moins partiellement reçue dans le logement 52.

Dans cette description, du fait des faibles valeurs autorisées pour l'angle α, on considère que la rotation de l'organe 32 entre ses première et deuxième configurations est réalisée essentiellement autour de l'axe X2, même lorsque l'angle α n'est pas nul.

Dans ce qui suit, pour simplifier la description, l'organe rotatif 32 ne présente pas un tel décalage. L'angle α est égal à 0° et l'axe X3 est confondu avec l'axe X2.

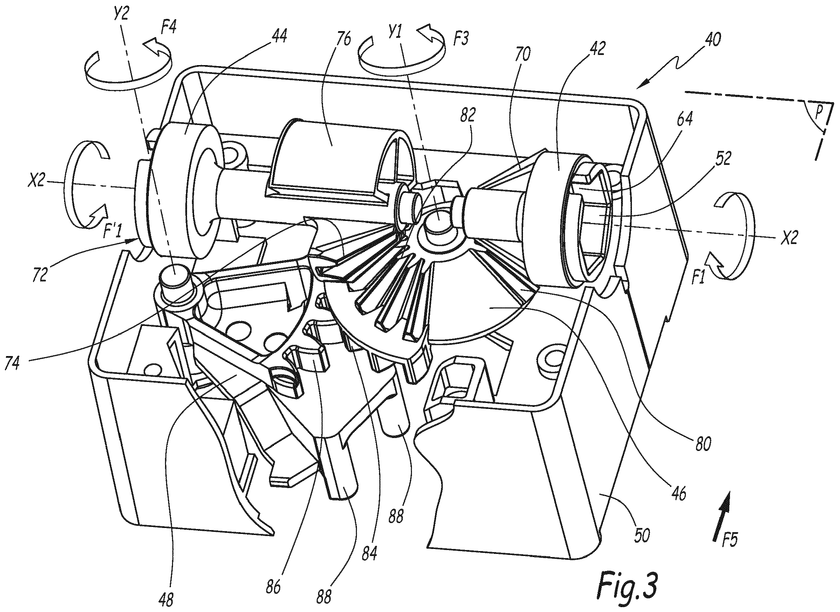

Dans cet exemple, comme illustré à la figure 3, le pignon 42 présente une forme essentiellement tronconique d'axe X2 et dont la base comporte la cavité 52. Le pignon 42 comporte une série de dents 70 ménagée sur son pourtour extérieur. Le pignon 42 engrène avec le pignon 46.

Le pignon 44 est mobile en rotation autour de l'axe X2 et est conformé pour recevoir l'organe rotatif 32'. Le pignon 44 joue, vis-à-vis de l'organe 32', le même rôle que le pignon 42 vis-à-vis de l'organe 32. Ainsi, tout ce qui est décrit en référence au pignon 42 s'applique au pignon 44. En particulier, le pignon 44 comporte un logement 72 conformé pour recevoir l'embout 54. Le pignon 44 comporte des dents 74 qui engrènent avec le pignon 46.

Avantageusement, le pignon 44 comporte une portion périphérique 76 solidaire en rotation du pignon 44 autour de l'axe X2 et dont une face est tournée vers l'extérieur de ce pignon 44. Le boîtier 50 comporte alors en outre une fenêtre 78 qui, lorsque le système 40 est dans un étant monté, débouche sur cette portion 76 de manière à la rendre visible depuis l'extérieur du boîtier 50. Des indicateurs visuels, par exemple les mentions « ON » et « OFF », sont placés sur la portion 76, en des emplacements prédéfinis et distincts de cette portion 76 pour indiquer la position dans laquelle se trouve le levier de commande 22.

Le pignon 46 engrène avec les pignons 42 et 44. Les pignons 42 et 44 sont placés d'un même côté du pignon 46. Le pignon 46 est mobile en rotation autour d'un axe fixe Y1 qui est perpendiculaire à l'axe X2 et au plan géométrique P. Le pignon 46 est apte à être couplé mécaniquement avec le levier 22 lorsque le dispositif 30 est monté sur l'appareil 20. Ici, le pignon 46 est indirectement couplé avec levier 22 au moyen du pignon 48. Par exemple, le pignon 46 s'étend essentiellement parallèlement par rapport au plan P. Le pignon 46 comporte ici deux séries de dents 80 et 82 qui sont engrenées respectivement avec les dents 70 et 74. Sur une face opposée aux pignons 42 et 44, le pignon 46 comporte une série de dents 84 qui est engrenée avec les dents 86 du pignon 48.

Le pignon 48 est mobile en rotation autour d'un axe fixe Y2 parallèle à l'axe Y1. Ici, ces deux axes Y1 et Y2 sont distants l'un de l'autre. L'axe Y2 est séparé du levier 22 par une distance D1, mesurée dans un plan géométrique parallèle au plan P. La distance D1 est par exemple supérieure ou égale à 2cm ou à 5cm. Ainsi, le pignon 48 joue le rôle d'un bras de levier, lui permettant d'exercer un effort suffisamment important sur le levier de commande 22 pour le déplacer entre les première et deuxième positions. Le pignon 48 comporte ici des griffes 88 qui sont disposées de part et d'autre du levier de commande 22 lorsque le dispositif 30 est monté sur l'appareil 20.

Sur les figures 3 et 4, les différents éléments constitutifs du système 40 sont illustrés dans leur position correspondant à la première position du levier 22. Pour commuter le levier 22 vers sa deuxième position, l'un ou l'autre des organes rotatifs de commande 32 et 32' est tourné depuis sa première configuration vers sa deuxième configuration en lui fournissant un mouvement de rotation autour de l'axe X2 dans le sens horaire relatif à cet organe rotatif 32 ou 32'.

Par exemple, la poignée 34 est tournée vers sa deuxième configuration dans le sens horaire illustré par la flèche F1. Alternativement, la poignée 34' est tournée vers sa deuxième configuration dans son sens horaire représenté par la flèche F'1. Ce mouvement de rotation de l'un ou l'autre des pignons 42 et 44 entraine la rotation du pignon 46 autour de l'axe Y1 comme illustré par la flèche F3 à la figure 3. Ainsi, du fait de la configuration du système 40, le pignon 46 tourne dans un même sens de rotation autour de l'axe Y1 lorsque chacun des pignons 42 ou 44 est mis en rotation autour de l'axe X2 dans son sens horaire. Ce mouvement de rotation du pignon 46 entraîne en rotation le pignon 48 autour de l'axe Y2 comme illustré par la flèche F4. Les griffes 88 exercent sur le levier de commande 22 un effort en translation orienté selon une direction parallèle au plan P, comme illustré par la flèche F5 aux figures 3 et 4. A l'issue de la rotation, le levier 22 est dans sa deuxième position. L'appareil électrique est dans son état électrique actif.

Pour déplacer le levier de commande 22 à nouveau vers sa première position, l'un ou l'autre des organes rotatifs 32 et 32' est mis en rotation vers sa première configuration, dans le sens opposé, c'est-à-dire dans le sens des flèches F2 ou F'2, respectivement. Cela fait tourner les pignons 46 et 48, dans un sens opposé aux flèches, respectivement F3 et F4 et déplace le levier de commande 22.

Ainsi, grâce au dispositif 40, un même organe rotatif 32 ou 32' est utilisable avec l'un ou l'autre des pignons 42 ou 44 pour commander le déplacement du levier 22. L'organe rotatif 32, 32' peut ainsi être placé indifféremment sur l'une ou l'autre des parois latérales 6 ou 8 de l'armoire 2. Il n'est donc pas nécessaire de prévoir des organes rotatifs distincts qui seraient spécifiquement adaptés pour être placés uniquement sur la face latérale droite 6 ou gauche 8. La fabrication du dispositif 30 est ainsi simplifiée. L'installation du dispositif 30 est également facilitée, car un utilisateur n'a pas besoin de se procurer un organe rotatif de commande spécifique selon qu'il souhaite positionner la poignée 34, 34' sur la face latérale droite 6 ou gauche 8 de l'armoire 2.

En outre, le pignon 46 couple la rotation des pignons 42 et 44 autour de l'axe X2. Ceci est avantageux dans le cas illustratif mais non obligatoire où le dispositif 30 comporte à la fois les organes rotatifs 32 et 32'. Ainsi, lorsque l'organe rotatif 32 est déplacé entre ses configurations par un utilisateur, l'organe 32', qui n'a pas été actionnée par l'utilisateur, est mécaniquement déplacé vers sa configuration correspondante. On évite ainsi que les poignées de commande 34 et 34' situées sur les parois latérales 6, 8 opposées de l'armoire 2 ne présentent des configurations différentes, ce qui serait préjudiciable pour un utilisateur qui ne saurait alors pas précisément dans quel état électrique se trouve l'appareil 20.

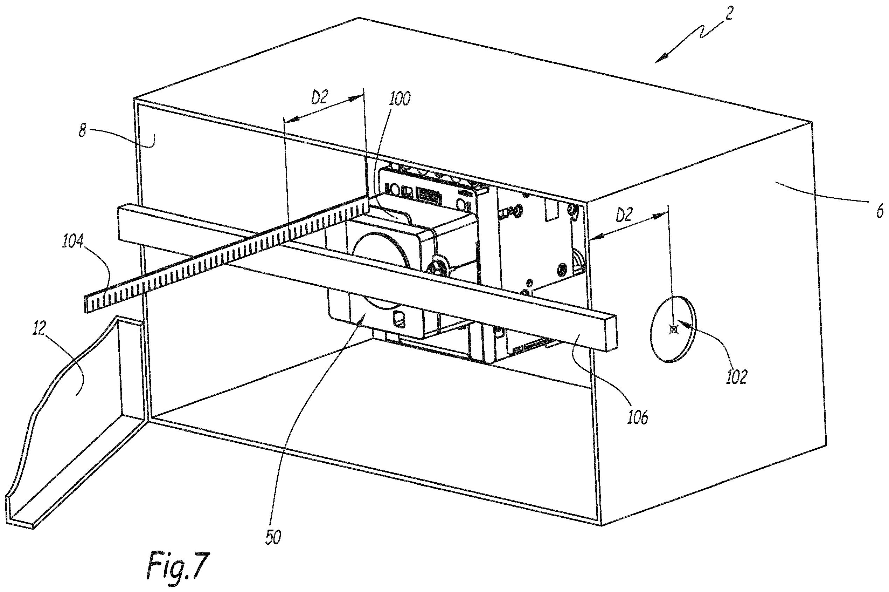

Avantageusement, le dispositif 40 comporte une languette 100 de positionnement, montée à l'extérieur du boîtier 50 et fait saillie par rapport au boîtier 50, de préférence sur une partie supérieure de ce boîtier 50, comme illustré à la figure 7. La languette 100 s'étend dans un plan géométrique parallèle au plan P et contenant l'axe de rotation X2. Par exemple, la languette 100 est une pièce mécanique intercalée entre des parties avant et arrière distinctes du boîtier 50. La languette 100 est de préférence en un matériau rigide, par exemple une matière plastique.

La languette 100 permet à un utilisateur, pendant l'installation du dispositif 30 sur l'appareil 20, de déterminer à quel emplacement un trou 102 doit être percé dans la paroi latérale 6 ou 8 pour permettre le passage de l'organe rotatif 32. Lorsque la porte 12 est ouverte, la languette 100 permet de recevoir en butée une règle 104 graduée s'étendant perpendiculairement au plan P et reposant sur une barre d'appui 106 disposé horizontalement parallèlement au plan P en appui contre les extrémités des parois latérales 6 et 8. La distance D2 qui sépare l'axe de rotation X2 du bord extérieur des parois 6 et 8 est ainsi facilement mesurable à l'aide de la règle 104. L'utilisateur peut ainsi, en rapportant cette distance D2 sur la paroi 6, facilement centrer le trou 102 sur l'axe X2, ce qui réduit le risque que l'organe rotatif 32 ou 32' soit installé dans une position désalignée par rapport à l'axe de rotation X2.

Avantageusement, comme illustré aux figures 8 à 10, le dispositif 30 comporte en outre un système de verrouillage 110 de la porte 12 dans sa position fermée. Sur les figures 8 à 10, l'organe rotatif 32' est ici omis.

Dans cet exemple, le système 110 comporte un crochet 112 et un anneau 114. Le crochet 112 et l'anneau 114 sont de formes complémentaires. Le crochet 112 est apte à être inséré dans l'anneau 114.

Dans cet exemple, le crochet 112 est monté fixement sur une face intérieure de la porte 12, par exemple, au moyen d'un support de fixation 116 solidaire à la porte 12 et pourvu d'une pluralité de trous de passage de vis. Le crochet 112 comporte, sur une portion d'attache, un ou plusieurs trous correspondants permettant, lorsqu'ils sont en face d'un trou respectif de passage du support 116, l'insertion d'une pièce de fixation 118, telle qu'une vis et un boulon.

L'anneau 114 est solidaire en rotation de l'organe rotatif 32. L'anneau 114 comporte un support d'attache 120 maintenu solidaire en rotation avec l'arbre 38 autour de l'axe X2, par exemple au moyen d'une vis 122. Bien entendu, l'anneau 114 pourrait tout aussi bien être placé sur l'organe rotatif 32'.

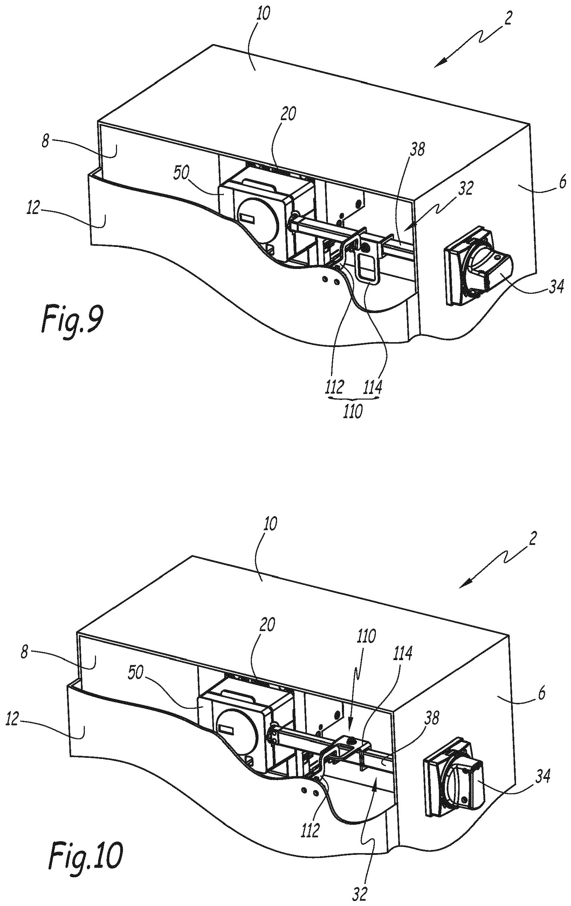

Lorsque la porte 12 est fermée, comme illustré aux figures 9 et 10, le dispositif de verrouillage 110 est déplaçable entre des positions de verrouillage et de déverrouillage de la porte 12, associées respectivement aux deuxième et première configurations de l'organe 32, et donc aux deuxième et premier états électriques de l'appareil électrique 20.

Dans la position de déverrouillage, illustrée à la figure 9, le crochet 112 est situé à l'extérieur de l'anneau 114, à distance de l'anneau 114. Le crochet 112 et l'anneau 114 peuvent être déplacés en translation l'un par rapport à l'autre sans entrave. Ainsi, le système de verrouillage 110 n'empêche pas l'ouverture de la porte 12.

Dans la position de verrouillage, illustrée à la figure 10, le crochet 112 est reçu à l'intérieur de l'anneau 114 et empêche tout déplacement en translation de l'anneau 114 par rapport au crochet 112. Ainsi, la porte 12 ne peut pas être ouverte.

Ainsi, la porte 12 est verrouillée tant que l'appareil électrique 20 est dans son état actif. Le système 110 ne déverrouille la porte 12 que lorsque l'organe rotatif 32 est manoeuvré dans sa première position, et donc que l'appareil électrique 20 est dans son état inactif. Un tel fonctionnement de la porte 12 est notamment imposé par des normes internationales relatives à la sécurité des équipements électriques.

En variante, le crochet 112 est solidaire de l'organe rotatif 32 et l'anneau 114 est monté sur la porte 12.

Le système de verrouillage 110 peut être utilisé indépendamment du système de transmission 40.

Les variantes et modes de réalisation décrits ci-dessus peuvent être combinés entre eux pour former de nouveaux modes de réalisation de l'invention.

## Revendications

1. Dispositif de commande (30) à distance d'un appareil électrique (20) dans une armoire électrique (2), cette armoire incluant une paroi de fond (4) et des parois latérales (6, 8) s'étendant essentiellement perpendiculairement par rapport à la paroi de fond et délimitant un logement (L), un appareil électrique (20) étant fixé, sur la paroi de fond, à l'intérieur du logement, ce dispositif comportant :
- un organe rotatif de commande (32), apte à être fixé sur une paroi de l'armoire (2) à l'extérieur du logement, cet organe rotatif de commande (32) étant sélectivement déplaçable entre des première et deuxième configurations,
- un système de transmission (40) apte à relier mécaniquement l'organe rotatif (32, 32') de commande à un levier de commande (22) de l'appareil électrique, ce levier de commande étant déplaçable entre des première et deuxième positions, le système de transmission (40) étant configuré pour que le déplacement de l'organe rotatif de commande (32, 32') entre ses première et deuxième configurations entraîne en déplacement le levier de commande (22) respectivement entre ses première et deuxième positions,
**caractérisé en ce que** :
- l'organe rotatif de commande (32, 32') est destiné à être monté sur une des parois latérales (6, 8) du logement et est mobile en rotation,
- le système de transmission (30) comporte :
• un premier pignon (42, 44), solidaire en rotation avec l'organe rotatif de commande (32, 32') autour d'un premier axe fixe (X2), essentiellement perpendiculaire aux parois latérales,
• un deuxième pignon (46), engrené avec le premier pignon (42, 44) et mobile en rotation autour d'un deuxième axe fixe (Y1) perpendiculaire au premier axe fixe, ce deuxième pignon (46) étant destiné à être couplé mécaniquement avec le levier de commande (22) pour déplacer ce levier de commande entre ses première et deuxième positions lorsque le deuxième pignon (42) se déplace en rotation.

2. Dispositif de commande (30) selon la revendication 1, **caractérisé en ce que** l'organe rotatif de commande (32, 32') comporte une poignée rotative (34, 34') montée sur la paroi latérale (6, 8) et un arbre (38, 38') s'étendant essentiellement le long d'un troisième axe (X3) et qui solidarise en rotation, autour du premier axe, une portion mobile de la poignée rotative (34, 34') avec le premier pignon (42, 44).

3. Dispositif de commande (30) selon la revendication 2, **caractérisé en ce que** l'organe rotatif de commande (32, 32') comporte un embout de liaison (54) avec le premier pignon, cet embout de liaison étant solidaire sans degré de liberté avec une extrémité de l'arbre (38, 38') et présentant une tête (56) reçue dans un logement (52) de forme complémentaire ménagé sur le premier pignon (42, 44) pour solidariser l'arbre (38, 38') en rotation avec le premier pignon.

4. Dispositif de commande (30) selon la revendication 3, **caractérisé en ce que** la tête (56) de l'embout de liaison (54) comporte un ergot (62) faisant saillie par rapport à cette tête selon une direction essentiellement perpendiculaire au troisième axe (X3) et **en ce que** le premier pignon (42) comporte une cavité (64) de forme complémentaire pour recevoir cet ergot lorsque l'embout (54) est reçu dans le logement (52).

5. Dispositif de commande (30) selon l'une des revendications 3 ou 4, **caractérisé en ce que** la tête (56) de l'embout de liaison (54) comporte une rotule (68), le premier pignon (42, 44) comportant un logement (52) de forme complémentaire pour recevoir cette rotule.

6. Dispositif de commande selon la revendication 5, **caractérisé en ce que** le troisième axe (X3) présente un décalage angulaire d'angle α par rapport au premier axe (X2), l'angle α présentant une valeur inférieure ou égale à 10°, de préférence à 5°, de préférence encore à 2°.

7. Dispositif de commande (30) selon l'une quelconque des revendications précédentes, **caractérisé en ce que** :
- le levier de commande (22) est déplaçable entre ses première et deuxième positions par déplacement (F5) dans une direction essentiellement parallèle au plan contenant le fond du logement ;
- le système de transmission (40) comporte un troisième pignon (48) engrené avec le deuxième pignon (46) et mobile en rotation autour d'un quatrième axe fixe (Y2) parallèle au deuxième axe fixe (Y1), ce troisième pignon comportant des griffes (88) conformées pour être disposées de part et d'autre du levier de commande (22).

8. Dispositif de commande (30) selon l'une quelconque des revendications précédentes, **caractérisé en ce que** le système de transmission (40) comporte un boîtier (50) à l'intérieur duquel sont disposés les premier (42, 44) et deuxième (46) pignons, ce boîtier (50) étant apte à être fixé sur l'appareil électrique (22) pour en commander le déplacement du levier de commande (22).

9. Armoire électrique (2), comportant :
- une paroi de fond (4) et des parois latérales (6, 8) s'étendant perpendiculairement par rapport à la paroi de fond, ces parois (4, 6, 8) délimitant un logement (L),
- un appareil électrique (20), fixé à l'intérieur du logement sur la paroi de fond et comportant un levier de commande (22) déplaçable entre des première et deuxième positions,
- un dispositif de commande (30) à distance de l'appareil électrique, comprenant :
• un organe rotatif de commande (32, 32'), fixé sur une paroi de l'armoire à l'extérieur du logement (L), ce organe rotatif de commande (32, 32') étant sélectivement déplaçable entre des première et deuxième configurations,
• un système de transmission (40) qui relie mécaniquement l'organe rotatif de commande au levier de commande, pour que le déplacement de l'organe rotatif de commande entre ses première et deuxième configurations entraîne en déplacement le levier de commande respectivement entre ses première et deuxième positions,
l'armoire électrique (2) étant **caractérisée en ce que** le dispositif de commande (30) à distance est conforme à l'une quelconque des revendications précédentes, l'organe rotatif de commande (32, 32') étant fixé sur une des parois latérales (6, 8) et étant mobile en rotation autour d'un troisième axe fixe (X3) essentiellement perpendiculaire à cette paroi latérale, le deuxième pignon (42, 44) étant couplé mécaniquement avec le levier de commande (22).

10. Armoire électrique (2) selon la revendication 9, **caractérisée en ce qu'**elle comporte :
- une porte (12) déplaçable sélectivement entre des positions d'ouverture et de fermeture du logement (L), et
- un système de verrouillage (110) de la porte dans sa position fermée, ce système de verrouillage comportant un crochet (112) et un anneau (114), l'un ou l'autre du crochet et de l'anneau, étant fixé sur une paroi intérieure de la porte (12), l'autre du crochet et de l'anneau étant monté sur le système de transmission (32, 32') et étant solidaire en rotation autour du troisième axe (X3) avec l'organe rotatif de commande, entre :
• une position de verrouillage, dans laquelle, lorsque la porte est dans la position fermée, le crochet pénètre à l'intérieur de l'anneau et empêche le déplacement de la porte vers sa position ouverte, et
• une position de déverrouillage, dans laquelle, lorsque la porte est dans la position fermée, le crochet et l'anneau sont distants l'un de l'autre et autorisent le déplacement de la porte vers sa position ouverte.

11. Armoire électrique (2) selon la revendication 10, **caractérisée en ce que** le dispositif est selon l'une des revendications 2 à 8 et l'autre (114) du crochet et de l'anneau est monté sur et solidaire en rotation avec l'arbre (38, 38').

## Patentansprüche

1. Vorrichtung (30) zur Fernsteuerung eines elektrischen Geräts (20) in einem Schaltschrank (2), wobei dieser Schrank eine Bodenwand (4) und Seitenwände (6, 8), die sich im Wesentlichen senkrecht zur Bodenwand erstrecken und einen Aufnahmeraum (L) begrenzen, einschließt, wobei ein elektrisches Gerät (20) an der Bodenwand im Inneren des Aufnahmeraums befestigt ist, wobei die Vorrichtung umfasst:
- ein drehbares Steuerelement (32), das geeignet ist, an einer Wand des Schranks (2) außerhalb des Aufnahmeraums befestigt zu werden, wobei dieses drehbare Steuerelement (32) selektiv zwischen einer ersten und einer zweiten Stellung bewegbar ist,
- ein Übertragungssystem (40), das geeignet ist, mechanisch das drehbare Steuerelement (32, 32') mit einem Steuerhebel (22) des elektrischen Geräts zu verbinden, wobei dieser Steuerhebel zwischen einer ersten und einer zweiten Position bewegbar ist, wobei das Übertragungssystem (40) derart ausgebildet ist, dass die Bewegung des drehbaren Steuerelements (32, 32') zwischen seiner ersten und zweiten Stellung eine Bewegung des Steuerhebels (22) jeweils zwischen seiner ersten und zweiten Position mit sich bringt,
**dadurch gekennzeichnet, dass**
- das drehbare Steuerelement (32, 32') vorgesehen ist, an Seitenwänden (6, 8) des Aufnahmeraums montiert zu werden und drehbeweglich ist,
- das Übertragungssystem (30) aufweist:
• ein erstes Ritzel (42, 44), das hinsichtlich der Drehung um eine erste feststehende Achse (X2) mit dem drehbaren Steuerelement (32, 32'), im Wesentlichen senkrecht zu den Seitenwänden, verbunden ist,
• ein zweites Ritzel (46), das mit dem ersten Ritzel (42, 44) im Eingriff ist und hinsichtlich der Drehung um eine zweite feststehende Achse (Y1), senkrecht zur ersten feststehenden Achse, beweglich ist, wobei dieses zweite Ritzel (46) vorgesehen ist, mechanisch mit dem Steuerhebel (22) gekoppelt zu werden, um diesen Steuerhebel zwischen seiner ersten und zweiten Position zu bewegen, wenn sich das zweite Ritzel (42) hinsichtlich einer Drehung bewegt.

2. Steuervorrichtung (30) nach Anspruch 1, **dadurch gekennzeichnet, dass** das drehbare Steuerelement (32, 32') einen drehbaren Griff (34, 34'), der an der Seitenwand (6, 8) montiert ist, und eine Welle (38, 38'), die sich im Wesentlichen entlang einer dritten Achse (X3) erstreckt und die ein bewegliches Teil des Drehgriffs (34, 34') mit dem ersten Ritzel (42, 44) um die erste Achse drehfest verbindet.

3. Steuervorrichtung (30) nach Anspruch 2, **dadurch gekennzeichnet, dass** das drehbare Steuerelement (32, 32') einen Ansatz (54) zum Verbinden mit dem ersten Ritzel aufweist, wobei dieser Verbindungsansatz ohne Freiheitsgrad mit einem Ende der Welle (38, 38') verbunden ist und einen Kopf (56) aufweist, der in einem Sitz (52) mit komplementärer Form, der in dem ersten Ritzel (42, 44) eingearbeitet ist, aufgenommen ist, um die Welle (38, 38') mit dem ersten Ritzel drehfest zu verbinden.

4. Steuervorrichtung (30) nach Anspruch 3, **dadurch gekennzeichnet, dass** der Kopf (56) des Verbindungsansatzes (54) eine Nase (62) aufweist, die in Bezug auf diesen Kopf gemäß einer im Wesentlichen senkrechten Richtung zur dritten Achse (X3) hervorragt, und dass das erste Ritzel (42) eine Kammer (64) in komplementärerer Form aufweist, um diese Nase aufzunehmen, wenn der Ansatz (54) in dem Sitz (52) aufgenommen ist.

5. Steuervorrichtung (30) nach einem der Ansprüche 3 oder 4, **dadurch gekennzeichnet, dass** der Kopf (56) des Verbindungsansatzes (54) ein Kugelelement (68) aufweist, wobei das Ritzel (42, 44) einen Sitz (52) komplementärer Form zum Aufnehmen dieses Kugelelements aufweist.

6. Steuervorrichtung (30) nach Anspruch 5, **dadurch gekennzeichnet, dass** die dritte Achse (X3) eine winkelmäßige Versetzung eines Winkels α in Bezug auf die erste Achse (X2) aufweist, wobei der Winkel α einen Wert kleiner oder gleich 10°, vorzugsweise 5°, noch bevorzugter 2° aufweist.

7. Steuervorrichtung (30) nach einem beliebigen der vorhergehenden Ansprüche, **dadurch gekennzeichnet, dass**:
- der Steuerhebel (22) zwischen seiner ersten und zweiten Position durch Verschiebung (F5) in eine im Wesentlichen parallel zur den Boden des Aufnahmeraums enthaltenen Ebene beweglich ist;
- das Übertragungssystem (40) ein drittes Ritzel (48), das mit dem zweiten Ritzel (46) im Eingriff ist und um eine vierte feststehende Achse (Y2) parallel zur zweiten feststehenden Achse (Y1) drehbeweglich ist, aufweist, wobei dieses dritte Ritzel Krallen (88) aufweist, die ausgebildet sind, beidseitig des Steuerhebels (22) angeordnet zu werden.

8. Steuervorrichtung (30) nach einem beliebigen der vorhergehenden Ansprüche, **dadurch gekennzeichnet, dass** das Übertragungssystem (40) ein Gehäuse (50) aufweist, in dessen Innerem das erste (42, 44) und zweite (46) Ritzel angeordnet sind, wobei dieses Gehäuse (50) geeignet ist, an dem elektrischen Gerät (22) befestigt zu werden, um darin die Bewegung des Steuerhebels (22) zu steuern.

9. Schaltschrank (2), umfassend:
- eine Bodenwand (4) und Seitenwände (6, 8), die sich senkrecht in Bezug auf die Bodenwand erstrecken, wobei diese Wände (4, 6, 8) einen Aufnahmeraum (L) definieren,
- ein elektrisches Gerät (20), das in dem Inneren des Aufnahmeraums an der Bodenwand befestigt ist und einen Steuerhebel (22) aufweist, der zwischen einer ersten und einer zweiten Position bewegbar ist,
- eine Vorrichtung (30) zur Fernsteuerung des elektrischen Geräts, umfassend:
• ein drehbares Steuerelement (32, 32'), das an einer Wand des Schranks außerhalb des Aufnahmeraums (L) befestigt ist, wobei dieses drehbare Steuerelement (32, 32') selektiv zwischen einer ersten und einer zweiten Stellung bewegbar ist,
• ein Übertragungssystem (40), das mechanisch das drehbare Steuerelement mit dem Steuerhebel derart verbindet, dass die Bewegung des drehbaren Steuerelements zwischen seiner ersten und zweiten Stellung eine Bewegung des Steuerhebels jeweils zwischen seiner ersten und zweiten Position mit sich bringt,
wobei der Schaltschrank (2) **dadurch gekennzeichnet ist, dass** die Vorrichtung (30) zur Fernsteuerung nach einem beliebigen der vorhergehenden Ansprüche ausgebildet ist, wobei das drehbare Steuerelement (32, 32') an einer der Seitenwände (6, 8) befestigt ist und um eine dritte feststehende Achse (X3) im Wesentlichen senkrecht zu dieser Seitenwand drehbeweglich ist, wobei das zweite Ritzel (42, 44) mechanisch mit dem Steuerhebel (22) gekoppelt ist.

10. Schaltschrank (2) nach Anspruch 9, **dadurch gekennzeichnet, dass** er umfasst:
- eine Tür (12), die wahlweise zwischen einer Offenposition und einer Schließposition des Aufnahmeraums (L) bewegbar ist, und
- ein System (110) zum Verriegeln der Tür in seiner Schließposition, wobei dieses Verriegelungssystem einen Haken (112) und einen Ring (114) aufweist, wobei eines der Bauteile Haken und Ring an der Innenwand der Tür (12) befestigt ist und das andere der Bauteile Haken und Ring an den Übertragungssystem (32, 32') befestigt ist und um die dritte Achse (X3) mit dem drehbaren Steuerelement drehfest verbunden ist zwischen:
• einer Verriegelungsposition, in der der Haken in das Innere des Rings eingreift und die Bewegung der Tür in ihre Offenposition verhindert, wenn die Tür in der Schließposition ist, und
• eine Entriegelungsposition, in der der Haken und der Ring voneinander entfernt sind und die Bewegung der Tür in ihre Offenposition gestattet, wenn die Tür in ihrer Schließposition ist.

11. Schaltschrank (2) nach Anspruch 10, **dadurch gekennzeichnet, dass** die Vorrichtung nach einem der Ansprüche 2 bis 8 ausgebildet ist und das andere (114) der Bauteile Haken und Ring oder der Haken an der Welle (38, 38') drehfest montiert ist.

## Claims

1. Remote control device (30) for an electrical apparatus (20) in an electrical cabinet (2), the cabinet including a bottom wall (4) and side walls (6, 8) extending substantially perpendicularly relative to the bottom wall and delimiting a housing (L), an electrical apparatus (20) being fixed to the bottom wall inside the housing, the device comprising:
- a rotary control member (32) capable of being fixed to a wall of the cabinet (2) outside the housing, the rotary control member (32) being selectively displaceable between first and second configurations,
- a transmission system (40) capable of mechanically connecting the rotary control member (32, 32') to a control lever (22) of the electrical apparatus, the control lever being displaceable between first and second positions, the transmission system (40) being so configured that the displacement of the rotary control member (32, 32') between its first and second configurations causes the displacement of the control lever (22) between its first and second positions, respectively,
**characterised in that**:
- the rotary control member (32, 32') is to be mounted on one of the side walls (6, 8) of the housing and is movable in rotation,
- the transmission system (30) comprises:
• a first pinion (42, 44) which is secured in rotation with the rotary control member (32, 32') about a first fixed axis (X2) substantially perpendicular to the side walls,
• a second pinion (46) which is meshed with the first pinion (42, 44) and movable in rotation about a second fixed axis (Y1) perpendicular to the first fixed axis, the second pinion (46) being intended to be coupled mechanically with the control lever (22) in order to displace the control lever between its first and second positions when the second pinion (42) moves in rotation.

2. Control device (30) according to claim 1, **characterised in that** the rotary control member (32, 32') comprises a rotary handle (34, 34') mounted on the side wall (6, 8) and a shaft (38, 38') which extends substantially along a third axis (X3) and secures a movable portion of the rotary handle (34, 34') in rotation, about the first axis, with the first pinion (42, 44).

3. Control device (30) according to claim 2, **characterised in that** the rotary control member (32, 32') comprises a connecting end-piece (54) for connection with the first pinion, the connecting end-piece being secured to one end of the shaft (38, 38') without any degree of freedom and having a head (56) which is received in a housing (52) of complementary shape formed on the first pinion (42, 44) in order to secure the shaft (38, 38') in rotation with the first pinion.

4. Control device (30) according to claim 3, **characterised in that** the head (56) of the connecting end-piece (54) comprises a lug (62) projecting relative to the head in a direction substantially perpendicular to the third axis (X3), and **in that** the first pinion (42) has a cavity (64) of complementary shape for receiving the lug when the end-piece (54) is received in the housing (52).

5. Control device (30) according to either claim 3 or claim 4, **characterised in that** the head (56) of the connecting end-piece (54) comprises a ball (68), the first pinion (42, 44) comprising a housing (52) of complementary shape for receiving the ball.

6. Control device according to claim 5, **characterised in that** the third axis (X3) has an angular offset of angle α relative to the first axis (X2), the angle α having a value of less than or equal to 10°, preferably less than or equal to 5°, yet more preferably less than or equal to 2°.

7. Control device (30) according to any one of the preceding claims, **characterised in that**:
- the control lever (22) is displaceable between its first and second positions by displacement (F5) in a direction substantially parallel to the plane containing the bottom of the housing;
- the transmission system (40) comprises a third pinion (48) which is meshed with the second pinion (46) and movable in rotation about a fourth fixed axis (Y2) parallel to the second fixed axis (Y1), the third pinion comprising prongs (88) configured to be arranged on either side of the control lever (22).

8. Control device (30) according to any one of the preceding claims, **characterised in that** the transmission system (40) comprises a casing (50) inside which the first (42, 44) and second (46) pinions are arranged, the casing (50) being capable of being fixed to the electrical apparatus (22) in order to control the displacement of the control lever (22) thereof.

9. Electrical cabinet (2), comprising:
- a bottom wall (4) and side walls (6, 8) extending perpendicularly relative to the bottom wall, the walls (4, 6, 8) delimiting a housing (L),
- an electrical apparatus (20) fixed inside the housing to the bottom wall and comprising a control lever (22) which is displaceable between first and second positions,
- a remote control device (30) for the electrical apparatus, comprising:
• a rotary control member (32, 32') fixed to a wall of the cabinet outside the housing (L), the rotary control member (32, 32') being selectively displaceable between first and second configurations,
• a transmission system (40) which mechanically connects the rotary control member to the control lever so that the displacement of the rotary control member between its first and second configurations causes the displacement of the control lever between its first and second positions, respectively,
the electrical cabinet (2) being **characterised in that** the remote control device (30) is in accordance with any one of the preceding claims, the rotary control member (32, 32') being fixed to one of the side walls (6, 8) and being movable in rotation about a third fixed axis (X3) substantially perpendicular to that side wall, the second pinion (42, 44) being mechanically coupled with the control lever (22).

10. Electrical cabinet (2) according to claim 9, **characterised in that** it comprises:
- a door (12) which is selectively displaceable between opening and closing positions of the housing (L), and
- a locking system (110) for locking the door in its closed position, the locking system comprising a hook (112) and a ring (114), one or other of the hook and the ring being fixed to an inside wall of the door (12), the other of the hook and the ring being mounted on the transmission system (32, 32') and being secured in rotation about the third axis (X3) with the rotary control member, between:
• a locking position, in which, when the door is in the closed position, the hook penetrates into the ring and prevents the door from being displaced to its open position, and
• an unlocking position, in which, when the door is in the closed position, the hook and the ring are apart from one another and allow the door to be displaced to its open position.

11. Electrical cabinet (2) according to claim 10, **characterised in that** the device is in accordance with any one of claims 2 to 8 and the other (114) of the hook and the ring is mounted on and secured in rotation with the shaft (38, 38').
